# EUROPEAN PATENT SPECIFICATION

(11) **EP 0 928 026 B1**
(45) Date of publication and mention of the grant of the patent: **23.07.2003**
(21) Application number: 98123179.8
(22) Date of filing: 04.12.1998
(51) Int. Cl.: H01L 23/13, H01L 23/66

(54) **Plastic Moulded Package for a Semiconductor Device**
Gegossenes Kunststoffgehäuse für ein Halbleiterbauelement
Boîtier moulé en plastique pour un dispositif semi-conducteur

(30) Priority: 10.12.1997 JP 34035997
(43) Date of publication of application: 07.07.1999
(73) Proprietor: Hitachi, Ltd., Chiyoda-ku, Tokyo 101-8010 (JP)
(72) Inventor: Fukuda, Kazuyuki, Niihari-gun, Ibaraki-ken (JP); Shimaoka, Makoto, Ushiku-shi (JP); Kaneko, Satoshi, Yokohama-shi (JP); Iwafuji, Yasunori, Yokohama-shi (JP)
(74) Representative: Strehl Schübel-Hopf & Partner

(56) References cited:
- EP-A- 0 578 411
- WO-A-97/15077
- US-A- 5 200 367
- US-A- 5 483 740
- PATENT ABSTRACTS OF JAPAN vol. 096, no. 005, 31 May 1996 -& JP 08 018163 A (NIPPON TELEGR & TELEPH CORP), 19 January 1996
- PATENT ABSTRACTS OF JAPAN vol. 009, no. 102 (E-312), 4 May 1985 -& JP 59 229840 A (ROOMU KK), 24 December 1984

## Description

The present invention relates to a semiconductor device package for accommodating a semiconductor device having a conductive circuit pattern formed on a plastic molded article and an optical fiber optically coupled with the semiconductor device. More particularly, the present invention relates to a semiconductor device package suitable for a modulation frequency band ranging from MHz to GHz.

A technology relating to the formation of a waveguide circuit pattern on a plastic molded article of this kind is described in JP-A-5-183254, for example.

According to this prior art reference, a metal film such as copper plating is formed on the whole surface of a cubic plastic molded article used as a circuit component in the field of electric and electronic appliances, and a resist is then applied to the copper plating by electrodeposition coating. Next, ultra-violet rays of a high pressure mercury lamp are irradiated to a predetermined circuit pattern depicted on a photomask to transfer the circuit pattern to the resist, and the resist pattern is developed to expose the copper plating of the circuit portion. Nickel plating and gold plating are applied to the circuit portion of the copper plating so exposed, and the resist remaining at portions other than the circuit portion and the copper plating below the resist are removed to form the conductive circuit pattern on the surface of the cubic plastic molded article.

WO-A-97/15077 discloses a semiconductor device package which has the features included in the first part of claim 1. In this package, the heat generated by an electronic component is radiated directly by the mold resin which has a high heat conductivity, without using fins.

In another semiconductor device package known from EP-A-0 578 411, the heat from the electronic component is similarly radiated directly by the mold resin of high heat conductivity. Fins are provided above a substrate to avoid a lead wire fixed on the substrate.

JP-A-8-18163 describes a semiconductor device in which the heat generated by a semiconductor laser, which is provided within a case formed of light shielding resin, is radiated through a coaxial stem formed of metal.

In prior art technology, a conductive circuit wiring of nickel plating and gold plating is formed on the surface of the plastic molded article by using the copper plating as the base. When such a molded article is used as a circuit component in the field of electric and electronic appliances, it can be used as the circuit component by soldering or packaging electric or electronic components or semiconductor chips to the conductive circuit wiring.

However, when the plastic molded article having the conductive circuit wiring is used as a circuit component in the field of optical communication in a frequency band ranging from MHz to GHz bands, for example, reflection and loss of electric signals are likely to occur at an electric connection portion between this circuit component and other circuit components. Therefore, its application is limited to a frequency band lower than the MHz band, and the plastic molded article is not suitable for use in the field having a strong requirement for high speed transfer such as optical communications.

However, even when a semiconductor device package comprises a plastic molded article having a conductive circuit pattern formed thereon and even when the frequency band is high such as in the MHz and GHz bands, the present invention can accomplish a semiconductor device package capable of driving the semiconductor laser device at high speed without causing reflection and loss of electric signals.

The semiconductor laser module is used for an optical source of optical communication and is produced by optically coupling a semiconductor device and an optical fiber. To reduce the production cost of the semiconductor laser module, the number of components of the module and the production cost must be reduced. To reduce the production cost, therefore, various proposals and developments have been made to package the semiconductor device and the optical fiber on a silicon substrate to a hybrid circuit and to mold the package by a plastic material. On the other hand, higher speed transfer has been required for the semiconductor laser module but the construction which simultaneously satisfies the requirement for the plastic module and the requirement for higher transfer speed has not yet been examined sufficiently.

### SUMMARY OF THE INVENTION

It is an object of the present invention to provide a semiconductor device package capable of driving a semiconductor laser device at high speed without causing reflection and loss of electric signals even in a high frequency band ranging from MHz to GHz.

It is another object of the present invention to provide an economical semiconductor device package capable of high speed driving and transfer.

It is still another object of the present invention to provide a semiconductor device package capable of improving heat radiation efficiency and enabling semiconductor laser oscillation to be stably effected without generating the drop of a laser output power and fluctuation of an oscillation wavelength.

These objects are met by the present invention as defined in claim 1. The invention provides a semiconductor device package which is suitable for high speed transfer, and a semiconductor laser module using the package.

In an embodiment of the invention, the conductive circuit.pattern which is disposed in the package and electrically connected to the semiconductor device comprises a microstrip line, and this conductive circuit pattern is formed three-dimensionally in the resin molded article. Since this construction does not employ the conventional construction which generates reflection and loss of the electric signals supplied from outside to the semiconductor device, it can drive the semiconductor device at high speed without causing reflection and loss of the electric signals even when the frequency band is high such as the MHz and GHz bands. In other words, because the three-dimensional microstrip line can be formed in an arbitrary shape on the surface of the resin molded article, the problems encountered when the semiconductor device is driven at high modulation frequency, such as the wiring length and impedance matching, can be solved. Consequently, a semiconductor device package and hence, a semiconductor laser module, that can cope with high speed transfer, can be accomplished.

The package for accommodating the semiconductor device and the optical fiber connected optically to the semiconductor device comprises the resin molded article and the conductive circuit pattern is formed on the surface of the resin molded article. Therefore, the package components and the conductive circuit components can be constituted integrally and the production cost of the semiconductor device package can be reduced.

The protuberances that constitute the electrode lead terminals connected electrically to the semiconductor device and form the conductive circuit pattern and the heat radiation fins are molded integrally with the resin-molded semiconductor device package from the same resin as that of the semiconductor device package at the time of molding of the latter. Therefore, the present invention can provide a surface package type semiconductor laser module which has high packageability by connecting the protuberances constituting the electrode lead terminals to the printed substrate, and which can radiate highly efficiently exothermy of the semiconductor device when it is driven even by using the resin molding material having a low heat transfer rate, and which can obtain stable laser oscillation without the drop of the laser output power and fluctuation of the oscillation wavelength.

The semiconductor device package comprising the plastic molded article having the conductive circuit pattern formed thereon and capable of driving the semiconductor laser device at high speed without causing reflection and loss of the electric signals even when the frequency is high, and the semiconductor laser module using the package.

The conductive circuit pattern connected electrically to the laser diode comprises the microstrip line, and the protuberances constituting the electrode lead terminals and the heat radiation fins are integrally molded with the resin-molded package. Since the problems of the wiring length of the signal transfer line to the laser diode and impedance matching can be thus solved, the laser diode can be driven at high speed without causing reflection and loss of the electric signals even when the modulation frequency band is high such as the MHz to GHz band. In consequence, the semiconductor device package and the semiconductor laser module that can cope with high speed transfer can be accomplished. The semiconductor laser module can be mounted in the surface package type having high packageability by connecting the protuberances to the printed substrate, and exothermy of the Laser diode when it is driven can be efficiently radiated by the heat radiation fins even when the plastic material having a low heat transfer rate is used, so that a stable optical output can be obtained without the drop of the laser output power and fluctuation of the oscillation wavelength. Furthermore, the production cost can be reduced because the package components and the conductive circuit components (the conductive circuit pattern, particularly, the microstrip line) can be integrally shaped by the plastic molded article.

### BRIEF DESCRIPTION OF THE DRAWINGS

Fig. 1 is a perspective view showing a construction of a semiconductor device package, which is not an embodiment of the present invention.
Fig. 2 is a perspective view showing a construction of a semiconductor laser module assembled by using the semiconductor device package of Fig. 1.
Fig. 3 is a perspective view showing a construction when the semiconductor laser module assembled by using the semiconductor device package of Fig. 1 is packaged to a printed substrate.
Fig. 4 is a longitudinal sectional view showing a semiconductor laser module according to a first embodiment of the invention.
Fig. 5 is a longitudinal sectional view showing a sectional construction of a semiconductor laser module according to a second embodiment of the invention.
Fig. 6 is a longitudinal sectional view showing a sectional construction of a semiconductor laser module according to a third embodiment of the present invention.
Fig. 7 is a partial exploded perspective view showing a construction of the semiconductor laser module of Fig. 6.
Fig. 8 is a plan view taken along the arrow A - A and showing an electric wiring structure of the semiconductor laser module shown in Fig. 6.

### DETAILED DESCRIPTION OF THE DRAWINGS

In the drawings, parts of electrode wirings, bonding leads, lead terminals and adhesives have been omitted for the sake of simplicity.

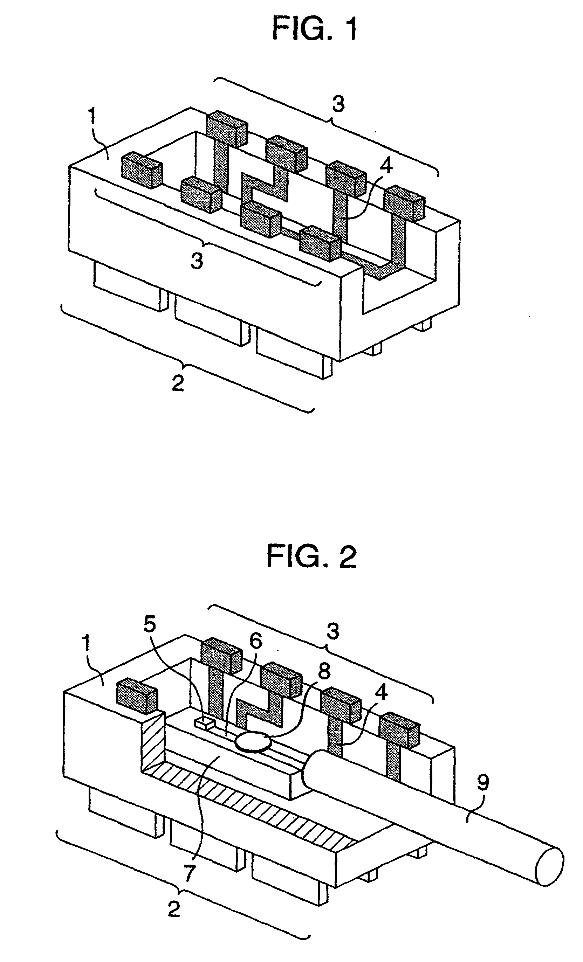

First, the semiconductor device package shown in Figs. 1 to 3 will be explained, which does not form an embodiment of the invention. The package 1 is a resin-molded article shaped from a plastic material into a hollow box shape, a conductive circuit pattern 4 formed three-dimensionally by patterning in multiple layers on the surface of this package 1, a silicon substrate 7 bonded and fixed to the bottom of the package 1 and equipped with a V groove (not shown) for installing an optical fiber 6, and a semiconductor device (laser diode) 5 mounted to the silicon substrate 7. The optical fiber 6, which is a single mode fiber coupled optically with the laser diode 5, for executing optical transfer, is installed in the V groove described above, and the whole assembly inclusive of this optical fiber 6 is referred to as a "semiconductor laser module".

A plurality of heat radiation fins 2 are disposed in alignment on one of the end faces of the package 1 (bottom surface of the package; lower side in Fig. 1), and a plurality of protuberances 3 constituting electrode lead terminals connected to a printed substrate 10 for electric connection with the semiconductor device 5 are disposed on the upper surface of the side wall of the package 1 opposing the heat radiation fins 2 (upper surface of the package; upper side in Fig. 1). The conductive circuit pattern 4 for electric connection is formed three-dimensionally in multiple layers on, and fitted to, the surface of the package 1 and is connected to each of the electrode lead terminals (protuberances) 3. The heat radiation fins 2 and the protuberances 3 of the electrode lead terminals are formed simultaneously and integrally with the package 1 at the time of resin-molding of the package 1 into a unitary structure. The mold-resin of the package 1, the heat radiation fins 2 and the protuberances 3 of the electrode lead terminals may be the same material. This embodiment uses a material which has high adhesion with the conductive circuit pattern 4 and has by itself a high heat resistance and a high strength, such as a liquid crystal polymer, as the plastic material of the package 1. The number of the electrode lead terminals 3 of the package 1 of this embodiment is 8. The liquid crystal polymer used in this embodiment will be explained briefly. The liquid crystal polymer is a material having a chemical structure such that its rigid molecules are oriented unidirectionally while keeping a difficultly bendable molecular state even under a molten state and are solidified as-oriented when they are cooled. The features of such a material are high elastic modulus, low linear expansion rate, high heat resistance (up to 260°C), etc, and the material is suitable as a plastic material that constitutes the package 1.

Next, the construction of the semiconductor laser module formed by mounting the semiconductor device 5 and the optical fiber 6 to the package 1 shown in Fig. 1 will be explained. Fig. 2 is a partial sectional perspective view showing the construction of the semiconductor laser module formed by fitting the semiconductor device 5 and the optical fiber 6 into the package 1. Speaking broadly, the semiconductor laser module comprises the laser diode 5 as the semiconductor device, the optical fiber 6 as the single mode fiber for effecting optical transfer, coupled optically with the laser diode 5, the silicon substrate 7 to which the laser diode 5 is mounted and which is equipped with the V groove (not shown) for installing the optical fiber 6 and the plastic-molded package 1 which accommodates these constituent elements, to which the silicon substrate 7 is bonded and fixed, and which is equipped with the heat radiation fins 2 and the protuberances 3 of the electrode lead terminals.

The silicon substrate 7 is bonded and fixed to the inner bottom surface of the package 1. The V groove (not shown) is formed on the upper surface of the silicon substrate 7 by anisotropic etching, and the optical fiber 6 is installed into this V groove by the adhesive 8. On the other hand, an electrode wiring (not shown) of conductive circuit pattern is formed by patterning on the upper surface of the silicon substrate 7, and the laser diode 5 is mounted to a predetermined position on this wiring. The laser diode 5 is mounted with markers (not shown) formed in advance on the electrode wiring on the upper surface of the silicon substrate 7 as registration marks. Wire bonding leads (not shown) are fitted to the laser diode 5 through the electrode wirings on the upper surface of the silicon substrate 7 so that the laser diode 5 can be electrically connected to the microstrip line 4 as the conductive circuit pattern 4 (partially omitted from the drawings) formed on the surface of the package 1. Silicon (Si) is used hereby as the material that constitutes the silicon substrate 7. The V groove of the silicon substrate 7 has a predetermined width and depth so that when the optical fiber 6 is installed, the center axis of the optical fiber 6 is in conformity with the laser outgoing axis of the laser diode 5 mounted to the upper surface of the silicon substrate 7. The optical coupling portion between the laser diode 5 and the optical fiber 6 is covered with a transparent gel-like resin (not shown) having high laser beam permeability. A cover 9 of the optical fiber 6 taken out from the package 1 is fixed to the side wall portion of the package 1 by applying an adhesive 12.

The package 1 is formed integrally with the heat radiation fins 2 and the protuberances 3 of the electrode lead terminals by molding the plastic material. The side wall portion of the package 1 from which the optical fiber 6 is taken out is removed so that the optical fiber 6 can be easily disposed. The thickness of the package 1 is 4.5 mm from the distal end of the heat radiation fins 2 to the distal end of the protuberance 3 of the electrode lead terminal, its width is 6.0 mm and its length is 15.0 mm.

The assembly procedure of the package 1 is as follows. First, the mold resin is poured into a mold heated from 300 to 350°C and a predetermined pressure is applied for one to two minutes. The molded package 1 is then withdrawn from the mold. The package 1 so withdrawn has the heat radiation fins 2 and the protuberances 3 of the electrode lead terminals.

Here, the pouring inlet of the mold resin is disposed at the edge of the package 1 so that the orientation direction of the molecular chains of the liquid crystal polymer used as the plastic material of the package 1 becomes unidirectional and the molecules are oriented in the direction of the optical axis of the optical fiber 6. It is advisable to set the pouring inlet of the resin to the inner bottom surface of the package on the side where the cover 9 of the optical fiber 6 is taken out or at the corner portion of the heat radiation fins 2, for example. Though the resin pouring inlet may be set to other suitable positions, it may be set so long as the molecules can be oriented in substantially the same direction as the direction of the optical axis of the optical fiber 6 and the set position described above is not particularly limited. When the orientation direction of the molecules of the liquid crystal polymer is set to the direction substantially the same as the optical axis direction of the optical fiber 6, the elastic modulus can be increased in this direction while the coefficient of linear expansion can be decreased. Accordingly, even when any external force and thermal deformation are applied, the position error of the coupling portion between the laser diode 5 and the optical fiber 6 does not occur so easily and stable optical coupling can be obtained. To efficiently conduct molding of the package 1, the heat radiation fins 2 and the protuberances 3 of the electrode lead terminals are provided with an inclination of 10 to 15 degrees, for example, so that the package 1 can be easily released from the mold after molding.

Base plating such as copper plating is applied to the whole surface of the resulting package 1. After a resist is applied to the copper plating, a circuit pattern depicted in a photomask is transferred to the resist and development is then carried out to expose the copper plating at the circuit portion. The microstrip line 4 is formed at a part of the circuit pattern. Nickel plating or gold plating and a resin coating to serve as an insulating layer are applied to the circuit portion of the copper plating so exposed, and the resist remaining at portions other than the circuit portion and the copper plating below the resist are removed. In this way, the package 1 having the conductive circuit pattern 4 and the microstrip pattern line 4 equipped with the insulating layer formed three-dimensionally on the surface thereof can be completed.

When the conductive circuit pattern 4 is to be formed inside the package 1, too, the package has a double-shot structure. First, a predetermined conductive circuit pattern 4 and a microstrip line 4 are formed in the package 1 and this package 1 is again molded to form the conductive circuit pattern 4 inside the package 1, too.

Next, the method of assembling the semiconductor laser module will be explained. First, the laser diode 5 is positioned and mounted to the silicon substrate 7 by using the markers (not shown) of the electrode wirings on the surface of the silicon substrate 7 as the registration marks. Next, the silicon substrate 7 to which the laser diode 5 is mounted is coupled with the inner bottom surface of the package 1 having the conductive pattern 4 formed thereon. The laser diode 5 and the electrode wirings on the upper surface of the silicon substrate 7, and the electrode wirings of the silicon substrate 7 and the conductive circuit pattern 4, are electrically connected by wire bonding leads (not shown), respectively. Next, the optical fiber 6 is installed into the V groove of the silicon substrate 7 and is fixed to the V groove by the adhesive 8. The procedures from the installation to fixing of the optical fiber 6 will be explained more concretely. Laser oscillation is generated by supplying a current to the laser diode 5 so that optical coupling between the laser diode 5 and the optical fiber 6 becomes maximal. Receiving the laser beam, the optical fiber 6 is positioned at the position at which the optical output from the optical fiber 6 attains the maximum. Under this state, the optical fiber 6 is pushed into the V groove of the silicon substrate 7 and is fixed by the adhesive 8. The adhesive 8 is applied in advance into the V groove, and is also applied from above after the optical fiber 6 is fitted into the V groove lest the optical fiber 6 undergoes the positioning error. After the optical fiber 6 is fixed to the silicon substrate 7 by the adhesive 8 in this way, the adhesive 12 is charged to the cover portion 9 of the optical fiber 6 taken out from the side surface of the package 1 and is then left standing inside an oven so as to completely set the respective adhesives 8 and 12. A UV-setting resin capable of setting within a short time is hereby used for the adhesives 8 and 12. After the optical fiber 6 is fixed to the silicon substrate 7, a gel-like resin is charged into the package 1 and evacuation is done inside a vacuum chamber to remove foams inside the resin and to complete charging of the resin into the optical coupling portion between the laser diode 5 and the optical fiber 6. Thereafter, the assembly is left standing inside the oven to set the gel-like resin, and the assembly work of the semiconductor laser module is completed.

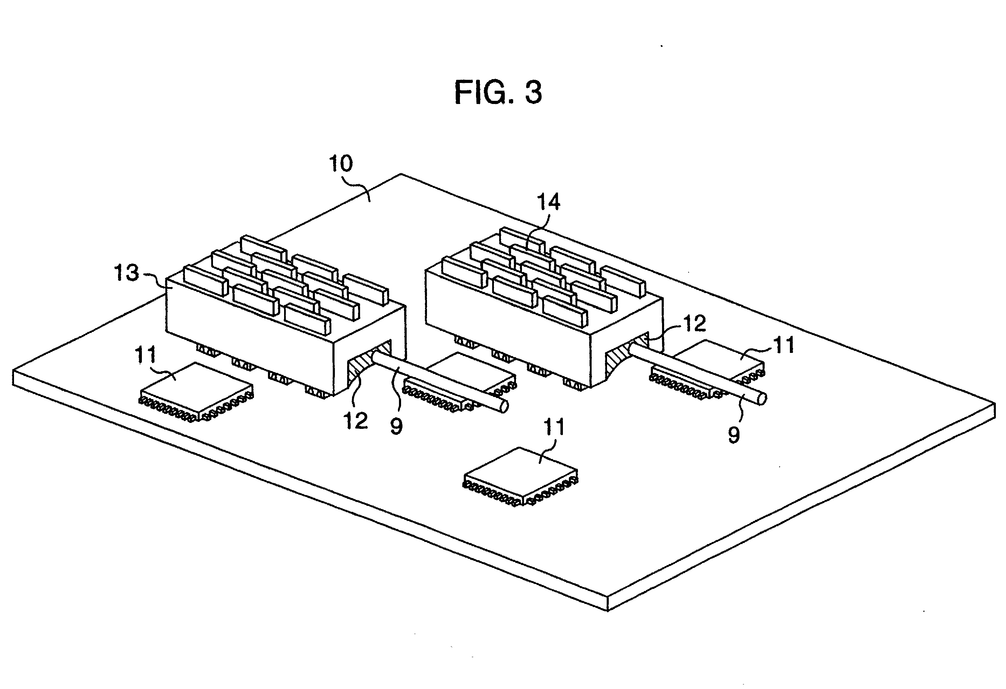

Next, the state where the semiconductor laser modules 13 and 14 of this embodiment are packaged to the printed substrate 10 will be explained with reference to Fig. 3.

Fig. 3 shows the state where the semiconductor laser modules 13 and 14 are packaged to the printed substrate 10, and driving ICs 11 for driving and controlling the modules are together mounted to the printed substrate 10. Though resistor devices and capacitors are also mounted, they are omitted from the drawing. In the drawing, two semiconductor laser modules, i.e. a transmission module 13 and a reception module 14, are together mounted as the semiconductor laser modules, to one printed substrate 10. The driving Ics 11 are disposed in the proximity of these modules 13 and 14 at electrically optimum positions. The modules 13 and 14 are mounted in the surface package type in which the protuberances 3 of the electrode lead terminals are soldered to predetermined positions on the printed substrate 10. The adhesive 12 is charged to the cover 9 of the optical fiber 6, for example.

Two methods are available for soldering; one is a reflow system which collectively solders all the electronic components such as the modules 13 and 14, the driving Ics 11, etc, to the printed substrate 10 and the other post-solders the modules 13 and 14. In the case of the reflow system, the optical fiber 6 using a coating having high heat resistance is used because the heat resistance of the cover 9 of the optical fiber 6 is low, or a heat-resistant protective tube is fitted to the cover 9 of the optical fiber 6 to prevent the temperature rise. When the modules 13 and 14 are post-soldered, a method is preferably employed which executes spot-heating for soldering by laser irradiation or beam irradiation.

In the package described above, the conductive circuit pattern connected electrically and externally to the laser diode 5 comprises the microstrip line, and this conductive circuit pattern 4 is formed is the package 1 which is resin-molded three-dimensionally. Moreover, the protuberances 3 that constitute the electrode lead terminals and the heat radiation fins 2 are integrally molded with the package 1 at the time of molding of the package 1. Consequently, since this embodiment does not employ the conventional construction which generates the reflection and loss of the electric signals supplied from outside to the laser diode 5, the package according to this embodiment can drive the laser diode 5 at a high speed without the reflection and loss of the electric signals even when the frequency band is high, such as the Mhz to Ghz bands. In other words, since the signal transmission line from the conductive circuit pattern 4 formed on the package 1 comprises the microstrip line, the problems of the wiring length and impedance matching encountered when the laser diode 5 is driven at a high modulation frequency can be solved. Consequently, this embodiment can accomplish the package 1 and the semiconductor laser modules 13 and 14 that can cope with high speed transfer.

Furthermore, the semiconductor laser modules 13 and 14 can be fitted in the surface package type having high packageability by connecting the protuberances 3 to the printed substrate 10, and even when a plastic material having a low heat transfer rate is used, exothermy at the time of driving of the laser diode 5 can be efficiently radiated by the heat radiation fins. Therefore, a stable optical output can be obtained without the drop of the laser output power and fluctuation of the oscillation wavelength. Because the package 1 is constituted by the plastic molded article and the conductive circuit pattern 4 inclusive of the microstrip line 4 is formed on the surface of the package 1, the components of the package 1 and the components of the conductive circuit portion can be molded integrally and the cost of production can be reduced.

Therefore, even when the package comprises the molded article having the conductive circuit pattern 4 formed thereon and even when the modulation frequency is high, this embodiment can obtain the semiconductor device accommodation package capable of driving the laser diode 5 at a high speed without causing the reflection and loss of the electric signals, and the semiconductor laser modules 13 and 14 using this package.

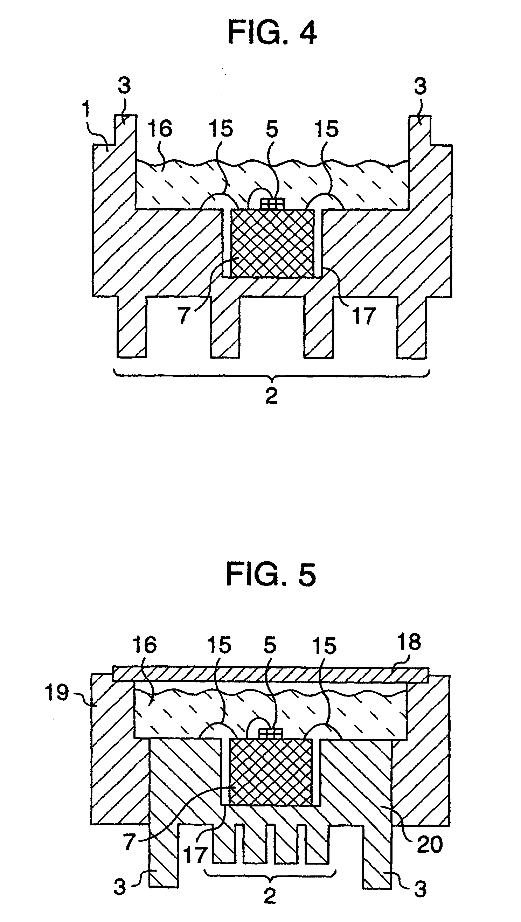

A first embodiment of the present invention will be explained with reference to Fig. 4. In this embodiment, a level difference portion or trench 17 for accommodating and packaging the silicon substrate 7 is defined inside the package 1. Like reference numerals will be used in this drawing to identify like constituent elements in the same way as in Fig. 1 to 3 and a detailed explanation of such members will be omitted.

Fig. 4 shows a longitudinal sectional structure of the semiconductor laser module according to this embodiment. The difference of the semiconductor laser module of this embodiment from the semiconductor laser module of Figs. 1 to 3 is that the level difference portion 17 for accommodating and packaging the silicon substrate 7 inside the package 1 is defined in the trench form at the bottom of the package 1. The level difference portion 17 for accommodating and packaging the silicon substrate 1 is formed on the surface opposing the fitting surface of the heat radiation fins 2 of the package 1. The silicon substrate 7 is fitted to the bottom of the level difference portion 17, that is, to the bottom of the trench-shaped recess. The distance from the fitting surface of the silicon substrate 7 to the heat radiation fins 2 (the thickness of the package 1 at the bottom of the level difference portion 17) is preferably small in order to improve heat radiation efficiency. In other words, the thickness of the surface of the package 1, on which the heat radiation fins 2 are disposed, is preferably small. This thickness is suitably from 0.1 to 0.3 mm. Because the level difference portion 17 is formed in the package 1, the thickness of the package 1 at the position of the level difference portion 17 becomes small, but the package 1 is free from the problem of breakage, etc, due to the drop of the strength because portions other than the level difference portion can be formed to a sufficient thickness. The depth of the level difference portion 17 is set to be equal to the height of the silicon substrate 7 so as to reduce the,difference of the level between the upper surface of the silicon substrate 7 and that of the level difference portion 17 when the silicon substrate 7 is fitted and to thus reduce the length of the wire bonding leads 15. Incidentally, the transparent resin 16 is applied by potting into the package 1, that is, to the optical coupling portion between the laser diode 5 and the optical fiber 6 on the silicon substrate 7, after the silicon substrate 7 and the wire bonding leads 15 are fitted.

In the embodiment having the construction described above, the distance between the silicon substrate 7 and the heat radiation fins 2 can be made smaller than that in the first embodiment. Therefore, heat radiation can be effected efficiently in combination with the electrode lead terminals 3 and the stable optical output can be obtained without causing the drop of the laser output power and fluctuation of the oscillation wavelength. The upper surface of the silicon substrate 7 and the upper surface of the level difference portion 17 inside the package 1 are set to the equal level and the length of the wire bonding leads to the conductive circuit pattern 4 inclusive of the microstrip line is reduced. In other words, the problems of the wiring length and impedance matching when the laser diode 5 is high-frequency driven can be solved, the semiconductor laser module that can cope with high frequency transfer can be accomplished.

Therefore, even when the package comprises the plastic molded article having the conductive circuit pattern 4 formed thereon and even when the modulation frequency is high, this embodiment can obtain the semiconductor device accommodation package capable of driving the laser diode 5 at a high speed without causing the reflection and loss of the electric signals and eventually, the semiconductor laser modules 13 and 14 using this package, can be obtained. This embodiment can also obtain the package 1 having a high heat radiation property of the heat generated from the laser diode 5. Since the construction of this embodiment is the same as that of Figs. 1 to 3 with the exception of the level difference portion 17, it can obtain the same effect.

The second embodiment of the present invention will be explained with reference to Fig. 5. In this embodiment, a package base 20 equipped with the level difference portion 17 and a package outer frame 19 equipped with side walls extending up beyond the upper surface of the level difference portion 17 and encompassing the outer periphery of the package 20 are molded by double-shot molding in such a manner as to dispose the heat radiation fins 2 and the protuberances 3 of the electrode lead terminals on the surface of the package base 20. Like reference numerals will be used in Fig. 5 to identify like constituent elements as in Figs. 1 to 4 and a detailed explanation of such members will be omitted. Fig. 5 shows a longitudinal section of the semiconductor laser module according to this embodiment.

The differences of the semiconductor laser module of this embodiment from the semiconductor laser module of Figs. 1 to 3 reside in that the package 1 is shaped by double-shot molding of the package outer frame 19 and the package base 20, the heat radiation fins 2 and the protuberances 3 of the electrode lead terminals are formed on the same surface of the package base 20 (the surface opposing the printed substrate 10, that is, the surface opposite to the surface having the level difference portion 17), and a cap 18 (a flat sheet member which is fitted to the upper end portion of the side walls and covers a zone defined by the upper surface of the level difference portion 17 of the package base 20 and the inner peripheral surface of the side walls of the package outer frame 19) is provided to the upper surface of the package outer frame 19. The level difference portion 17 for accommodating and packaging the silicon substrate 7 is formed in the package base 20. The heat radiation fins 2 and the protuberances 3 of the electrode lead terminals are formed by integral molding with the package base 20 equipped with the level difference portion 17. This package base 20 is again molded to form the package outer frame 19. The transparent resin 16 is charged by potting into the zone defined by the package outer frame 19, the package base 20 and the cap 18 so as to establish a simple hermetic zone in cooperation with the cap 18. The term "simple hermetic zone" used hereby means a hermetic zone capable of keeping the internal pressure below 10⁻⁸ Torrs.

The combination of a plastic material which is easy to mold the conductive circuit pattern 4 inclusive of the microstrip line and has high heat resistance and high strength with a plastic material capable of remolding is suitably used for the plastic materials that constitute the package base 20 and the package base 20 and the package outer frame 19. This embodiment uses the liquid crystal polymer, for example, as the plastic material that constitutes both the package outer frame 19 and the package base 20, and property values suitable for the intended application are selected.

According to this embodiment, the package outer frame 19 and the package base 20 are molded by double-shot molding. Therefore, the conductive circuit pattern 4 inclusive of the microstrip line can be formed not only on the surface of the package outer frame 19 that serves as the surface after completion of the package and on the surface of the package 20 but also at the portions which become the interior of the packager after its completion (the coupling surface between the package outer frame 19 and the package base 20), so that design of the electric wirings can be made optimally. Further, because the protuberances 3 of the electrode lead terminals can be disposed at arbitrary positions, the package outer frame 19 and the package base 20 suitable for high speed transfer can be obtained. Because packaging to the printed substrate 10 is not effected by the protuberances 3 of the electrode lead terminals alone but the heat radiation fins 2, too, are fitted to the printed substrate 10, heat radiation can be attained more efficiently and the semiconductor laser diode having the stable optical output can be obtained without causing the drop of the laser output power and fluctuation of the oscillation wavelength. Further, service life of the semiconductor laser diode can be extended by employing the simple hermetic structure. Because this embodiment employs the same construction as those of the first embodiment with the exception of double-shot molding and the cap 18, it can obtain the same effects as those of the first embodiment.

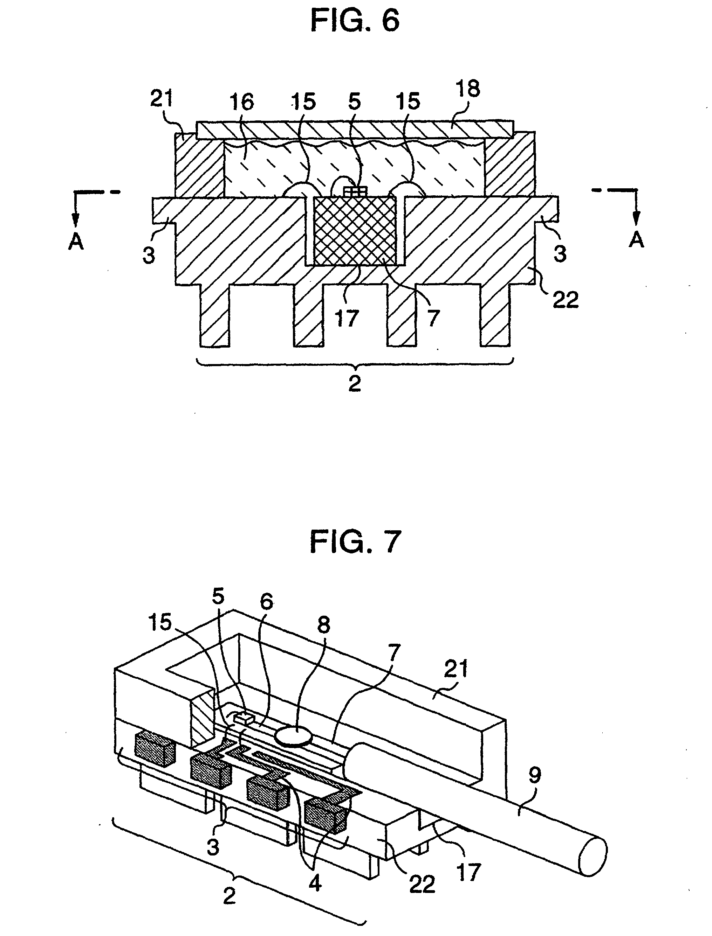

The third embodiment of the present invention will be explained with reference to Figs. 6 to 8. In this embodiment, the package 1 is shaped by double-shot molding of the package base 22 equipped with the level difference portion 17 and the package outer frame 21 coupled with the upper surface of the package base 22 and defining the side walls, the protuberances 3 of the electrode lead terminals are disposed on the side surfaces of the package base 22 and the heat radiation fins 2 are disposed on the bottom surface of the package base 22. Like reference numerals will be used in these drawings to identify like constituent elements as above , and an explanation of such members will be omitted.

Fig. 6 shows a longitudinal sectional structure of the semiconductor laser module according to this embodiment and Fig. 7 is a partial sectional perspective view. The differences of the semiconductor laser module of this embodiment from the semiconductor laser module of Figs. 1 to 3 are that the package 1 is formed by double-shot molding of the package outer frame 21 and the package base 22, the protuberances 3 of the electrode lead terminal are disposed on the side surfaces of the package base 22, the heat radiation fins 2 are disposed on the bottom surface of the package base 22 and the cap 18 (a flat sheet member fitted to the upper end portion of the side walls and covering the zone defined by the upper surface of the level difference portion 17 of the package base 22 and the inner peripheral surface of the side walls of the package outer frame 21) is provided to the upper surface of the package outer frame 21. The level difference portion 17 for accommodating and packaging the silicon substrate 7 is formed in the package base 22. The package base 22 having the level difference portion 17 includes the heat radiation fins 2 and the protuberances 3 of the electrode lead terminals that are molded integrally with the package base 22. The conductive circuit pattern 4 and the microstrip line 24 for electrically connecting the laser diode 5 and the electrode lead terminals 3 are formed on the surface of the package base 22. This package base 22 is again molded to form the package outer frame 21 as the framework of the package. The transparent resin 16 is charged by potting into the zone defined by the upper surface of the level difference portion 17 of the package base 22 and the inner peripheral surface of the side walls of the package outer frame 21 and the cap 18 is further fitted so as to establish the simple hermetic structure inside the zone. The combination of a plastic material capable of easily molding the conductive circuit pattern 4, and the microstrip line, a plastic material having high heat resistance and high strength, a plastic material capable of remolding, etc, is suitably used as the plastic material constituting the package base 22 and the package outer frame 21. Therefore, this embodiment uses the liquid crystal polymer, for example, as the plastic material of both of the package outer frame 21 and the package base 22, and property values suitable for the intended application are selected.

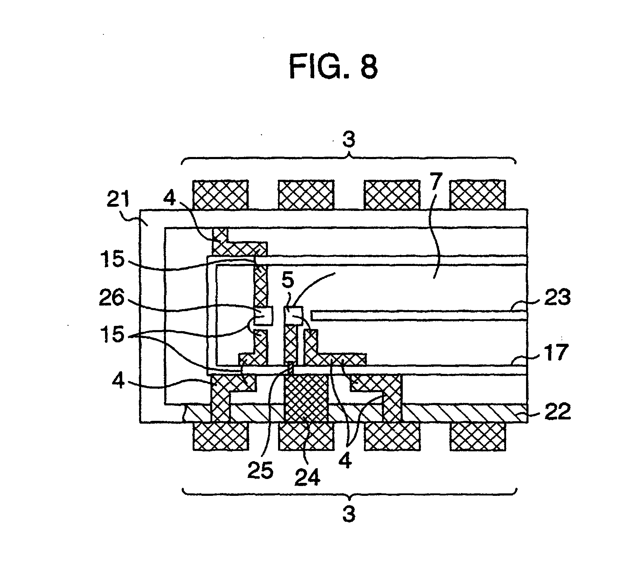

Fig. 8 is a top view showing the wiring structure of the conductive circuit pattern 4 and the microstrip line 24 formed on the package base 22. In this construction, a photodiode 26 is fitted to the upper surface of the silicon substrate 7 of the semiconductor laser module shown in Figs. 6 and 7 adjacent to the laser diode 5. The optical fiber 6 and the adhesive 8 are omitted from the drawing. The protuberances 3 of the electrode lead terminals electrically connected to the laser diode 5 and the photodiode 26 are disposed at two to four positions. The laser diode 5 and the photodiode 26 are electrically connected to the conductive circuit pattern 4 on the silicon substrate 7 through the wire bonding leads 15 while the conductive circuit pattern 4 on the silicon substrate 7 is electrically connected to the conductive circuit pattern 4 and the microstrip line 24 formed on the package base 22 through the wire bonding leads 15. The conductive circuit pattern on the surface of the package base 22 to be electrically connected to the laser diode 5 comprises the microstrip line 24 and is connected to the conductive circuit pattern 4 on the silicon substrate 7 through ribbon-like wirings 25. The microstrip line 24 has a multi-layered wiring structure equipped with insulating layers. Incidentally, the silicon substrate 7 is equipped with the V groove 23 for installing the optical fiber 7.

According to this embodiment having the construction described above, the conductive circuit pattern 4 and the microstrip line 14 formed on the package 22 have only a two-dimensional planar shape and three-dimensional bending occurs only around the protuberances 3 that constitute the electrode lead terminals. In other words, in comparison with the conductive circuit pattern 4 and the microstrip line 24 formed into the three-dimensional shape, the two-dimensional planar shape can reduce bending of the signal transfer lines, and the reflection and loss of the electric signals supplied from outside to the laser diode 5 can be further reduced, and the laser diode 5 can be driven at a high speed even when a modulation frequency is high such as in the MHz to GHz bands. In other words, the structure of the package outer frame 21 and the package base 22, and the semiconductor laser module suitable for high speed transfer can be accomplished. Because this embodiment employs the same construction as those of the first and second embodiments, it can obtain the same effect as before.

Though the first to third embodiment represent the semiconductor laser module using the laser diode 5 as the semiconductor device, a package suitable for high speed transfer can be accomplished by forming the semiconductor light reception module by mounting the photodiode in place of the laser diode 5 and in such a case, too, the same effect as those of the foregoing embodiments can be obtained.

The first to third embodiments represent the construction in which the laser diode 5 and the optical fiber 6 and the silicon substrate 7 having these elements mounted thereto are accommodated and packaged to the package 1, but the present invention is not particularly limited to these members. For example, the package of the present invention is not limited to these members and can be accomplished by the construction which together accommodates and packages the driving ICs 11 for driving and controlling the semiconductor devices. In this case, the number of the protuberances 3 of the electrode lead terminals increases because the number of electric connections with outside increases. However, the conductive circuit pattern 4 and the microstrip line 4 can be formed in an arbitrary shape by single-shot or double-shot molding of the plastic material, the number of the protuberances 3 of the electrode terminals can be increased or decreased easily and the positions of their disposition can be changed easily by a simple modification, and the construction can be constituted so as to cope with various shapes of the package 1.

The embodiments described above use the liquid crystal polymer for the plastic material constituting the package 1 but the present invention is not particularly limited thereto. Therefore, other plastic materials can be used for the package 1 of the semiconductor laser module capable of positioning in the order of sub-micron order such as in optical coupling between the laser diode 5 and the optical fiber 6 and fixing them semi-permanently so long as they have a high elastic modulus, a low thermal expansion coefficient, a high heat resistance (capable of withstanding solder reflow), etc. It is possible to use, for example, a composite material of heat setting type plastics prepared by mixing glass fibers, carbon fibers, glass fillers, and so forth.

## Claims

1. A semiconductor device package comprising:
a resin molded container (20, 22) with a semiconductor device (5) disposed on a main inner surface thereof, and
a conductive circuit pattern (4) formed inside said container (20, 22), being connected electrically to said semiconductor device (5), and having a portion constituted by a micro-strip circuit,
**characterised in that**
said semiconductor device (5) is a light detection device and/or a light emission device optically coupled to an optical fibre (6) having one end extending outside the package,
a main outer surface of said container (20, 22) opposite said main inner surface is provided with heat radiation fins (2), and
said semiconductor device (5) is disposed on the bottom of a trench (17) formed in the main inner surface.

2. The package of claim 1 wherein electrode lead terminals electrically connected to said conductive circuit pattern (4) are on a plurality of protuberances (3).

3. The package of claim 1 wherein said conductive circuit pattern (4) is formed three-dimensionally on the main inner surfaces of said container (20, 22).

4. The package of claim 1 wherein said heat radiation fins (2) are formed of molded resin.

5. The package of claim 1 wherein said conductive circuit pattern (4) is formed on opposite sides of said semiconductor device (5).

6. The package of claim 2, wherein said heat radiation fins (2) and said protuberances (3) are disposed on the same main outer surface of said container (20, 22).

7. The package of claim 2, wherein said heat radiation fins (2) and said protuberances (3) are disposed on opposite main outer surfaces of said container (20, 22).

8. A semiconductor system comprising a substrate (10) on which a driving IC (11) and a semiconductor device package according to any preceding claim are disposed.

9. The system of claim 8, wherein said package is a transmission module (13).

10. The system of claim 8, wherein said package is a reception module (14).

## Patentansprüche

1. Halbleiterbaugruppe mit
einem Kunststoff-Spritzgußbehälter (20, 22) mit einem auf einer Haupt-Innenfläche des Behälters angeordneten Halbleiterbauelement (5) und
einem innerhalb des Behälters (20, 22) ausgebildeten Leiterbahnmuster (4), das mit dem Halbleiterbauelement (5) elektrisch verbunden ist und einen von einer Mikrostrip-Schaltung gebildeten Teil aufweist,
**dadurch gekennzeichnet,**
**daß** das Halbleiterbauelement (5) eine lichterfassende und/oder eine lichtemittierende Vorrichtung ist, die mit einer Lichtleitfaser (6), deren eines Ende aus der Baugruppe nach außen verläuft, optisch gekoppelt ist,
**daß** die der Haupt-Innenfläche entgegengesetzte Haupt-Außenfläche des Behälters (20, 22) mit Wärmeabstrahlrippen (2) versehen ist, und
**daß** das Halbleiterbauelement (5) am Boden eines in der Haupt-Innenfläche ausgebildeten Grabens (17) angeordnet ist.

2. Baugruppe nach Anspruch 1, wobei mit dem Leiterbahnmuster (3) elektrisch verbundene Elektrodenanschlüsse auf mehreren Vorsprüngen (3) vorhanden sind.

3. Baugruppe nach Anspruch 1, wobei das Leiterbahnmuster (4) dreidimensional auf den Haupt-Innenflächen des Behälters (20, 22) ausgebildet ist.

4. Baugruppe nach Anspruch 1, wobei die Wärmeabstrahlrippen (2) aus geformten Kunststoff gebildet sind.

5. Baugruppe nach Anspruch 1, wobei das Leiterbahnmuster (4) auf entgegengesetzten Seiten des Halbleiterbauelements (5) ausgebildet ist.

6. Baugruppe nach Anspruch 2, wobei die Wärmeabstrahlrippen (2) und die Vorsprünge (3) auf der gleichen Haupt-Außenfläche des Behälters (20, 22) angeordnet sind.

7. Baugruppe nach Anspruch 2, wobei die Wärmeabstrahlrippen (2) und die Vorsprünge (3) auf entgegengesetzten Haupt-Außenflächen des Behälters (20, 22) angeordnet sind.

8. Halbleitersystem mit einem Substrat (10), auf dem eine integrierte Treiberschaltung (11) und eine Halbleiterbaugruppe nach einem der vorhergehenden Ansprüche angeordnet sind.

9. System nach Anspruch 8, wobei die Baugruppe ein Sendemodul (13) ist.

10. System nach Anspruch 8, wobei die Baugruppe ein Empfangsmodul ist.

## Revendications

1. Boîtier de dispositif à semiconducteurs, comprenant :
un conteneur moulé (20, 22) en résine, sur une surface intérieure principale duquel est disposé un dispositif (5) à semiconducteurs, et
un motif conducteur (4) de circuit formé à l'intérieur dudit conteneur (20, 22), connecté électriquement audit dispositif (5) à semiconducteurs et ayant une partie constituée par un circuit sur microbande,
**caractérisé en ce que**
ledit dispositif (5) à semiconducteurs est un dispositif de détection de lumière et/ou un dispositif d'émission de lumière à couplage optique avec une fibre optique (6) dont une extrémité s'étend à l'extérieur du boîtier,
une surface extérieure principale dudit conteneur (20, 22) opposée à ladite surface intérieure principale est munie d'ailettes (2) de rayonnement de chaleur, et
ledit dispositif (5) à semiconducteurs est disposé dans le fond d'une saignée (17) ménagée dans la surface intérieure principale.

2. Boîtier selon la revendication 1, dans lequel des bornes de connexion d'électrodes, connectées électriquement audit motif conducteur (4) de circuit se trouvent sur une pluralité de protubérances (3).

3. Boîtier selon la revendication 1, dans lequel ledit motif conducteur (4) de circuit est formé en trois dimensions sur la surface intérieure principale dudit conteneur (20, 22).

4. Boîtier selon la revendication 1, dans lequel lesdites ailettes (2) de rayonnement de chaleur sont en résine moulée.

5. Boîtier selon la revendication 1, dans lequel ledit motif conducteur (4) de circuit est formé sur des faces opposées dudit dispositif (5) à semi-conducteurs.

6. Boîtier selon la revendication 2, dans lequel lesdites ailettes (2) de rayonnement de chaleur et lesdites protubérances (3) sont disposées sur la même surface extérieure principale dudit conteneur (20, 22).

7. Boîtier selon la revendication 2, dans lequel lesdites ailettes (2) de rayonnement de chaleur et lesdites protubérances (3) sont disposées sur des surfaces extérieures principales opposées dudit conteneur (20, 22).

8. Système à semiconducteurs comprenant un substrat (10) sur lequel sont disposés un circuit intégré d'attaque (11) et un boîtier de dispositif à semiconducteurs selon l'une quelconque des revendications précédentes.

9. Système selon la revendication 8, dans lequel ledit boîtier est un module d'émission (13).

10. Système selon la revendication 8, dans lequel ledit boîtier est un module de réception (14).
